# EUROPEAN PATENT APPLICATION

(11) **EP 4 822 996 A1**
(43) Date of publication of application: **14.10.2026**
(21) Application number: 26166986.5
(22) Date of filing: 24.03.2026
(51) Int. Cl.: H03M 3/00

(54) **AD CONVERSION CIRCUIT, PHOTOELECTRIC CONVERSION DEVICE, AND IMAGE CAPTURING DEVICE**

(30) Priority: 07.04.2025 JP 2025063362
(71) Applicant: Canon Kabushiki Kaisha, Tokyo 146-8501 (JP)
(72) Inventor: KURIHARA, Takuya, Ohta-ku, Tokyo, 146-8501 (JP); FURUTA, Masanori, Ohta-ku, Tokyo, 146-8501 (JP)
(74) Representative: TBK

(57) **Abstract**

An AD conversion circuit (1) including a ΔΣ AD converter (10) including an integrating circuit, a holding circuit holding a signal output from the integrating circuit, a switching circuit (30) switching an input to the AD converter (10) between an input terminal (IN) of the AD conversion circuit (1) and the holding circuit, a digital demodulating circuit (40) generating a digital signal in accordance with a signal output from the AD converter (10), a digital gain adjustment circuit (60) performing gain adjustment for a signal output from the digital demodulating circuit (40), and an obtaining circuit (70) is provided. The obtaining circuit (70) obtains a correction value based on the digital signal output from the digital demodulating circuit (40) in accordance with a reference signal supplied to the input terminal (IN), and the gain adjustment in the digital gain adjustment circuit (60) is performed based on the correction value in an AD conversion mode.

## Description

### TECHNICAL FIELD

The present disclosure relates to an AD conversion circuit, a photoelectric conversion device, and an image capturing device.

### BACKGROUND

Japanese Patent Laid-Open No. 2024-153548 discloses, as a technique of downsizing a ΔΣ analog-to-digital (AD) converter, a two-stage continuous-time ΔΣ AD converter that performs AD conversion of high-order bits and low-order bits in time division. Also, Japanese Patent Laid-Open No. 2024-153548 discloses a technique of arranging a digital gain adjustment circuit that performs gain adjustment for a digital signal in order to improve the nonlinear distortion of the ΔΣ AD converter generated owing to the gain error of an amplifier circuit.

### SUMMARY

The gain error of the ΔΣ AD converter disclosed in Japanese Patent Laid-Open No. 2024-153548 can vary with, for example, fluctuations of the temperature and power supply voltage. Variations of the gain error mean variations of the optimal value of a correction value used in the digital gain adjustment circuit.

Some embodiments of the present disclosure provide a technique advantageous in improving the nonlinear error of a ΔΣ AD converter.

The present disclosure in its first aspect provides an AD conversion circuit as specified in claim 1. Optional features are specified in claims 2 to 12.

The present disclosure in its second aspect provides a photoelectric conversion device as specified in claims 13 and 14.

The present disclosure in its third aspect provides an image capturing device as specified in claim 15.

Features of the present disclosure will become apparent from the following description of embodiments with reference to the attached drawings. The following description of embodiments is described by way of example.

### BRIEF DESCRIPTION OF THE DRAWINGS

Fig. 1 is a block diagram showing a configuration example of an AD conversion circuit according to an embodiment;
Figs. 2A and 2B is a timing chart showing an example of the operation timing of the AD conversion circuit in Fig. 1;
Fig. 3 is a flowchart showing an example of a sequence of obtaining the correction value of the AD conversion circuit in Fig. 1;
Fig. 4 is a circuit diagram showing a configuration example of the ΔΣ AD converter of the AD conversion circuit in Fig. 1;
Fig. 5 is a circuit diagram showing a configuration example of the ΔΣ AD converter of the AD conversion circuit in Fig. 1;
Fig. 6 is a circuit diagram showing a configuration example of the ΔΣ AD converter of the AD conversion circuit in Fig. 1;
Fig. 7 is a block diagram showing a modification of the AD conversion circuit in Fig. 1;
Fig. 8 is a flowchart showing an example of a sequence of obtaining the correction value of the AD conversion circuit in Fig. 7;
Fig. 9 is a diagram showing a configuration example of a photoelectric conversion device including the AD conversion circuit according to the embodiment;
Fig. 10 is a circuit diagram showing a configuration example of the readout circuit of the photoelectric conversion device in Fig. 9;
Fig. 11 is a block diagram showing a configuration example of the AD conversion circuit of the photoelectric conversion device in Fig. 9;
Fig. 12 is a block diagram showing a configuration example of a photoelectric conversion system including the AD conversion circuit according to the embodiment; and
Figs. 13A and 13B are views showing a configuration example of a moving body including the AD conversion circuit according to the embodiment.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

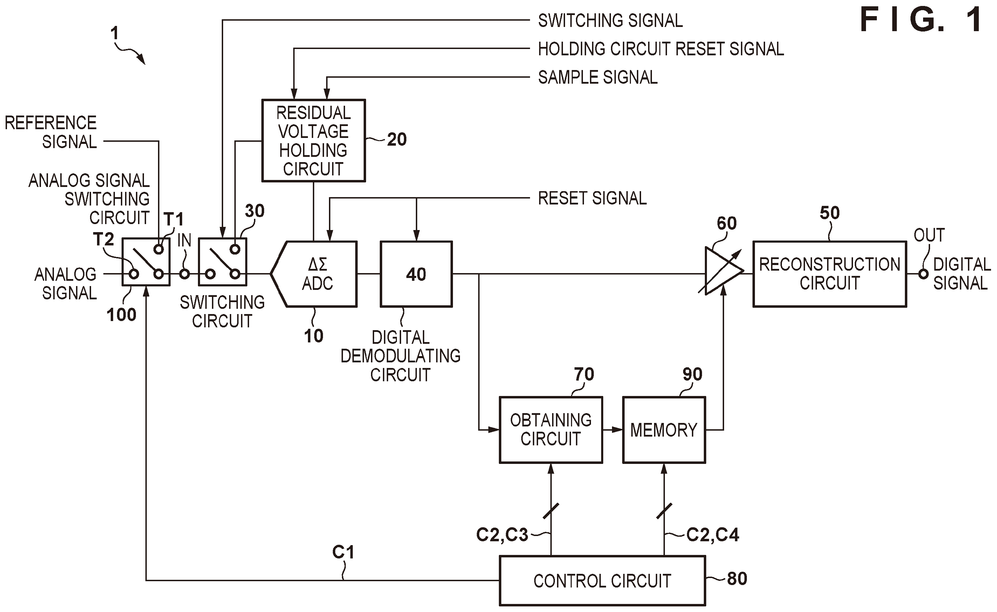

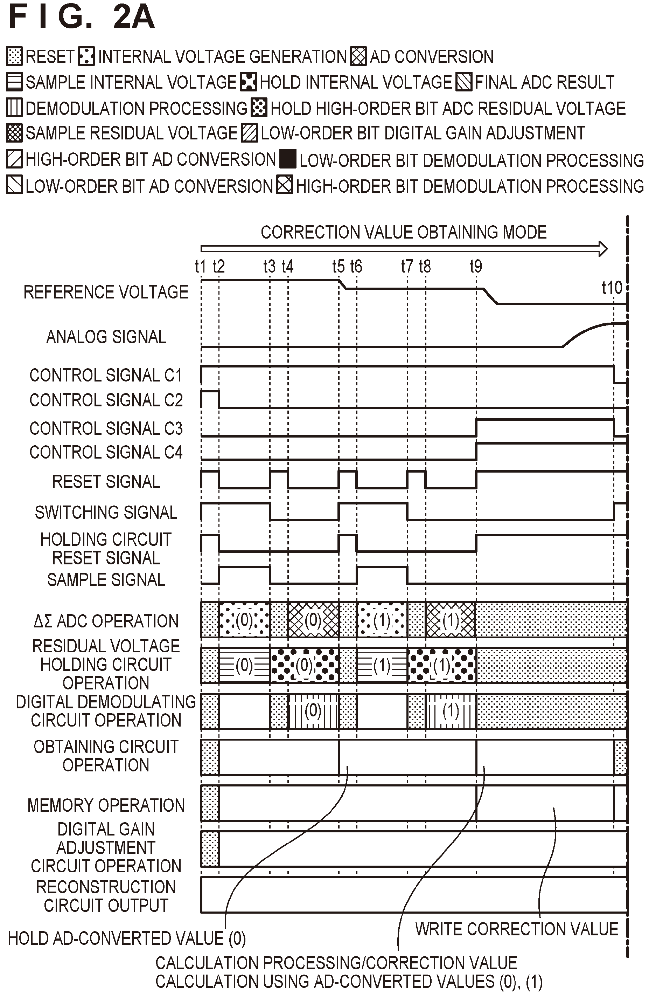

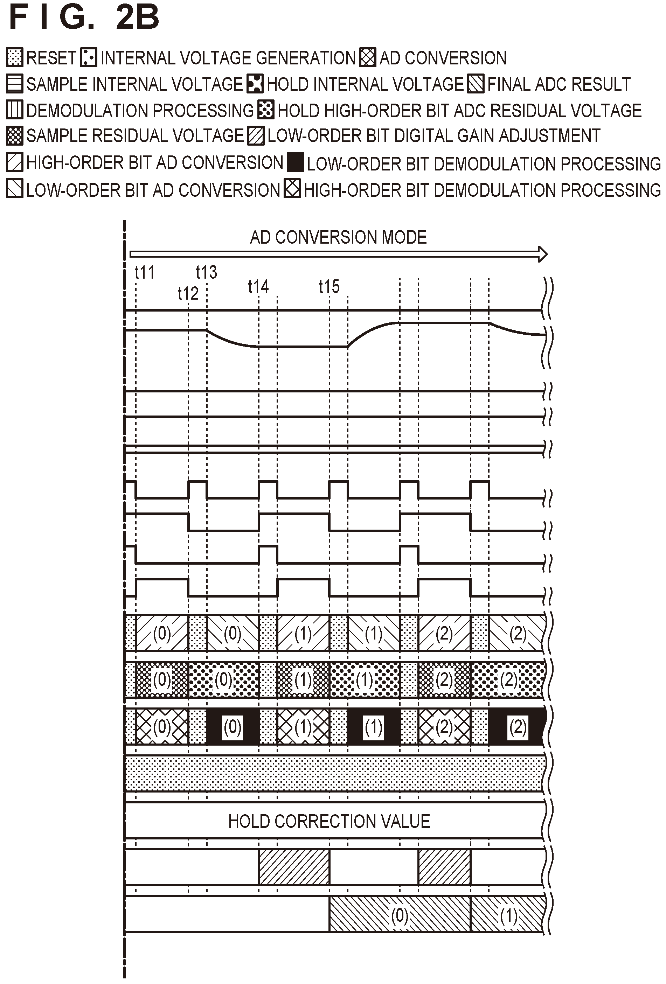

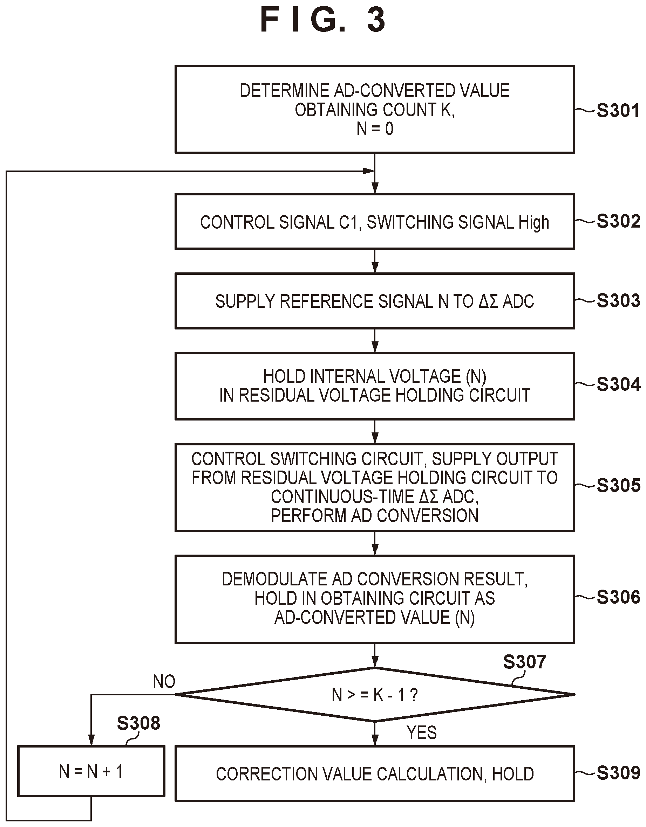

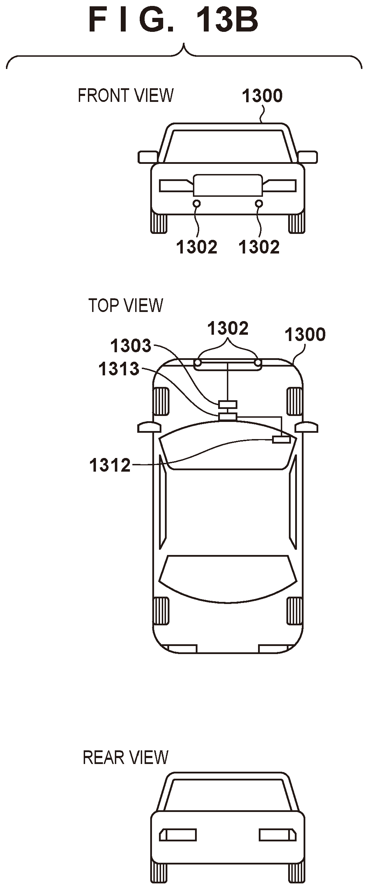

An AD conversion circuit according to an embodiment of the present disclosure that converts an analog signal into a digital signal will be described with reference to Fig. 1 to Figs. 13A and 13B. Fig. 1 is a block diagram showing a configuration example of an AD conversion circuit 1 according to the present disclosure. Figs. 2A and 2B are a timing chart showing an example of the operation timing of the AD conversion circuit 1. Fig. 3 is a flowchart showing an example of a sequence of obtaining a correction value in the AD conversion circuit 1.

The AD conversion circuit 1 is constituted as, for example, a two-stage ΔΣ AD converter. The AD conversion circuit 1 may be a continuous-time AD conversion circuit in which a ΔΣ AD converter 10 includes a continuous-time integrator, or a hybrid AD conversion circuit in which the ΔΣ AD converter 10 includes a continuous-time integrator and a discrete-time integrator. The AD conversion circuit 1 converts an analog signal supplied to an input terminal IN into a digital signal, and outputs the digital signal from an output terminal OUT. The AD conversion circuit 1 is constituted to be operable in a plurality of modes including an AD conversion mode in which a signal supplied to the input terminal IN is AD-converted, and a correction value obtaining mode. In the correction value obtaining mode, a correction value at the time of gain adjustment in a digital gain adjustment circuit 60 is obtained. In the AD conversion mode, a nonlinear error generated by variations of the gain error of the ΔΣ AD converter 10 can be improved. The configuration and operation of the AD conversion circuit 1 will be explained in detail below.

The AD conversion circuit 1 can include the ΔΣ AD converter 10 and a switching circuit 30. The AD conversion circuit 1 can also include a residual voltage holding circuit 20, a digital demodulating circuit 40, and a reconstruction circuit 50. Further, the AD conversion circuit 1 can include an obtaining circuit 70 to obtain a correction value in the correction value obtaining mode. The AD conversion circuit 1 can also include a control circuit 80 for controlling the obtaining circuit 70, a memory 90 for storing a correction value, and an analog signal switching circuit 100 serving as a switching circuit other than the switching circuit 30. The AD conversion circuit 1 is sometimes constituted without arranging the analog signal switching circuit 100, which will be described later.

The ΔΣ AD converter 10 can include an integrating circuit that integrates a difference signal. The ΔΣ AD converter 10 receives supply of an analog signal serving as an output from the switching circuit 30, and outputs a time-series ΔΣ modulated signal. The residual voltage holding circuit 20 is a holding circuit that holds a signal corresponding to a voltage output from the integrating circuit of the ΔΣ AD converter 10. The switching circuit 30 switches a signal to be supplied to the ΔΣ AD converter 10 between a signal supplied to the input terminal IN and a signal held in the residual voltage holding circuit 20. The digital demodulating circuit 40 generates (demodulates) a multibit digital signal corresponding to the time-series ΔΣ modulated signal output from the ΔΣ AD converter 10. The demodulated digital signal is supplied to the obtaining circuit 70 and the digital gain adjustment circuit 60, respectively.

Next, a configuration for obtaining a correction value used in gain adjustment in the digital gain adjustment circuit 60 will be explained. The control circuit 80 controls the obtaining circuit 70, the memory 90, and the analog signal switching circuit 100. The control circuit 80 supplies a control signal C1 to the analog signal switching circuit 100, supplies control signals C2 and C3 to the obtaining circuit 70, and supplies control signals C2 and C4 to the memory 90. The analog signal switching circuit 100 performs switching control between a terminal T1 to which a correction value obtaining reference signal (reference voltage) is input, and a terminal T2 to which an analog signal to be AD-converted in the AD conversion mode is input. The analog signal switching circuit 100 supplies, to the switching circuit 30 via the input terminal IN, a signal supplied to the terminal T1 or the terminal T2 selected by switching control. The obtaining circuit 70 is controlled by the control signals C2 and C3, performs processing of obtaining a correction value for reducing the nonlinear error of the ΔΣ AD converter 10 with respect to an output from the digital demodulating circuit 40, and outputs the processing result as a correction value to the memory 90. The obtaining circuit 70 obtains the correction value based on a digital signal output from the digital demodulating circuit 40 in accordance with the correction value obtaining reference signal supplied to the input terminal IN in the correction value obtaining mode. The memory 90 is controlled by the control signals C2 and C4, holds the correction value obtained by the obtaining circuit 70, and outputs it to the digital gain adjustment circuit 60.

The digital gain adjustment circuit 60 performs gain adjustment for a demodulated digital signal based on the correction value held in the memory 90 in the AD conversion mode. The gain-adjusted digital signal is supplied to the reconstruction circuit 50. The reconstruction circuit 50 generates an output digital signal based on the gain-adjusted digital signal.

Next, an operation example of the AD conversion circuit 1 will be explained with reference to Figs. 2A and 2B. Figs. 2A and 2B shows in time series the correction value obtaining reference signal, the analog signal, the control signals C1 to C4, a reset signal, a switching signal, a holding circuit reset signal, and a sample signal, which are shown in Fig. 1. Also, Figs. 2A and 2B shows similarly in time series the operations of the ΔΣ AD converter 10, residual voltage holding circuit 20, digital demodulating circuit 40, reconstruction circuit 50, obtaining circuit 70, memory 90, and digital gain adjustment circuit 60, which are shown in Fig. 1.

As described above, the AD conversion circuit 1 is configured to be operable in a plurality of modes including the AD conversion mode in which a signal supplied to the input terminal IN is AD-converted, and the correction value obtaining mode for obtaining a correction value. In the operation shown in Figs. 2A and 2B, the period from time t1 to time t10 is a period in which the AD conversion circuit 1 operates in the correction value obtaining mode. A period from time t11 is a period in which the AD conversion circuit 1 operates in the AD conversion mode. The operation of the AD conversion circuit 1 will be explained below in the order of the correction value obtaining mode and the AD conversion mode. Here, an operation in the correction value obtaining mode will be explained by exemplifying a case where reference signals of two types of voltages, that is, a reference signal V0 and a reference signal V1 are used.

First, a sequence until a correction value is obtained in the correction value obtaining mode will be explained. In the period from time t1 to time t10, the control signal C1 changes to the High state, and the analog signal switching circuit 100 selects the terminal T1 to which the reference signal is supplied. In the period from time t1 to time t5, the reference signal V0 is supplied to the terminal T1. In the period from time t1 to time t2, the reset signal changes to the High state to reset the ΔΣ AD converter 10 and the digital demodulating circuit 40. In the same period from time t1 to time t2, the holding circuit reset signal changes to the High state to reset the residual voltage holding circuit 20. Further, in the same period from time t1 to time t2, the control signal C2 changes to the High state to reset the obtaining circuit 70 and the memory 90. In the period from time t1 to time t3, the switching signal changes to the High state, and the switching circuit 30 connects the analog signal switching circuit 100 so that an output from the analog signal switching circuit 100 is supplied to the ΔΣ AD converter 10 via the input terminal IN. Then, the reference signal V0 is input to the ΔΣ AD converter 10. The reference signal V0 input to the ΔΣ AD converter 10 is amplified or attenuated by a coefficient determined by the design value of the internal circuit of the ΔΣ AD converter 10, and is held as an internal voltage (0) in the residual voltage holding circuit 20. The coefficient determined by the design value contains the errors of a gain and offset generated by, for example, the DC gain of an amplifier present inside the ΔΣ AD converter 10 or the residual voltage holding circuit 20. Letting gain be the coefficient determined by the design value of the internal circuit of the ΔΣ AD converter 10, er be the gain error, and of be the offset, the internal voltage (0) is given by equation (1):
$internal voltage \left(0\right) = gain \times er \times V 0 + of$ (1)

Then, at time t3, the sample signal changes to the Low state, and the residual voltage holding circuit 20 holds the internal voltage (0). At the same time t3, the switching signal changes to the Low state, and the internal voltage (0) serving as an output from the residual voltage holding circuit 20 is input to the ΔΣ AD converter 10. In the period from time t3 to time t4, the reset signal changes to the High state to reset the ΔΣ AD converter 10 and the digital demodulating circuit 40. In the period from time t4 to time t5, the ΔΣ AD converter 10 AD-converts the internal voltage (0), and the digital demodulating circuit 40 performs demodulation processing for the ΔΣ modulated signal output from the ΔΣ AD converter 10. The multibit demodulated signal of the internal voltage (0) obtained at this time is represented as an AD-converted value (0).

At time t5, the AD-converted value (0) is supplied to the obtaining circuit 70, and the obtaining circuit 70 holds the AD-converted value (0). The obtaining circuit 70 can include a memory (not shown) for holding the AD-converted value (0). In the period from time t5 to time t6, the reset signal changes to the High state to reset the ΔΣ AD converter 10 and the digital demodulating circuit 40. In the same period from time t5 to time t6, the holding circuit reset signal changes to the High state to reset the residual voltage holding circuit 20. Also, in the same period from time t5 to time t6, the signal supplied to the terminal T1 of the analog signal switching circuit 100 changes to the reference signal V1.

Then, in the period from time t6 to time t9, similar to the above-described period from time t2 to time t5, the ΔΣ AD converter 10, the residual voltage holding circuit 20, the digital demodulating circuit 40, and the obtaining circuit 70 are operated using the reference signal V1, thereby obtaining an AD-converted value (1). At time t9, the reset signal changes to the High state to reset the ΔΣ AD converter 10 and the digital demodulating circuit 40. At the same time t9, the holding circuit reset signal changes to the High state to reset the residual voltage holding circuit 20. Further, at the same time t9, the control signal C3 changes to the High state, and the obtaining circuit 70 starts processing of obtaining correction values using the AD-converted value (0) and the AD-converted value (1) held in the obtaining circuit 70. At the same time t9, the control signal C4 changes to the High state to write in the memory 90 the correction values obtained by the obtaining circuit 70, and the memory 90 holds the correction values. The correction values are values obtained by digitizing the gain error er and the offset of represented by equation (1), and are represented as Dig(er) and Dig(of), respectively.

In the correction value obtaining mode, the switching circuit 30 switches to supply the reference signal V0 to the ΔΣ AD converter 10 in the period from time t1 to time t3, and supply, to the ΔΣ AD converter 10 in the period from time t3 to time t5 after the period from time t1 to time t3, a voltage signal held in the residual voltage holding circuit 20 in accordance with a voltage output from the integrating circuit of the AD conversion circuit 1 at the end of the period from time t1 to time t3. In addition, the switching circuit 30 switches to supply the reference signal V1 to the ΔΣ AD converter 10 in the period from time t5 to time t7, and supply, to the ΔΣ AD converter 10 in the period from time t7 to time t9 after the period from time t5 to time t7, a voltage signal held in the residual voltage holding circuit 20 in accordance with a voltage output from the integrating circuit of the AD conversion circuit 1 at the end of the period from time t5 to time t7. The obtaining circuit 70 obtains a correction value based on the AD-converted value (0) serving as a digital signal generated by the digital demodulating circuit 40 in accordance with the ΔΣ modulated signal output from the ΔΣ AD converter 10 in the period from time t3 to time t5. In other words, the obtaining circuit 70 similarly obtains a correction value based on the AD-converted value (1) serving as a digital signal generated by the digital demodulating circuit 40 in accordance with the ΔΣ modulated signal output from the ΔΣ AD converter 10 in the period from time t7 to time t9.

Here, in the correction value obtaining mode, a plurality of types of reference signals including the reference signals VO and V1 are supplied, and the obtaining circuit 70 obtains correction values based on a plurality of digital signals (AD-converted value (0) and AD-converted value (1)) corresponding to the respective reference signals VO and V1 of the plurality of types output from the digital demodulating circuit 40. However, for example, when a temperature characteristic or a characteristic with respect to fluctuations of the power supply voltage is known for at least either of the gain error er and the offset of, the obtaining circuit 70 may obtain a correction value based on an AD-converted value corresponding to one reference signal.

Next, an operation example in the AD conversion mode after time t10 will be explained. At time t10, the control signal C1 changes to the Low state, and the analog signal switching circuit 100 selects the terminal T2 to which an analog signal is supplied. At the same time t10, the switching signal changes to the High state, and the switching circuit 30 connects the analog signal switching circuit 100 so that an output from the analog signal switching circuit 100 is supplied to the ΔΣ AD converter 10 via the input terminal IN. Then, an analog signal is input to the ΔΣ AD converter 10. At time t10, therefore, the analog signal is supplied to the ΔΣ AD converter 10. At time t11, the reset signal changes to the Low state, and the ΔΣ AD converter 10 starts AD conversion equivalent to a high-order bit string. At the same time t11, the residual voltage holding circuit 20 starts sampling of a residual voltage output from the integrator of the ΔΣ AD converter 10, and the digital demodulating circuit 40 starts demodulation processing of the high-order bit string corresponding to the ΔΣ modulated signal output from the ΔΣ AD converter 10. At time t12, after the end of the AD conversion equivalent to the high-order bit string, the residual voltage holding circuit 20 holds a voltage signal corresponding to the residual voltage of the ΔΣ AD converter 10, and the reconstruction circuit 50 obtains a multibit demodulated signal equivalent to the high-order bit string. At the same time t12, the switching signal changes to the Low state, and the switching circuit 30 switches to supply, to the ΔΣ AD converter 10, a voltage signal held in the residual voltage holding circuit 20. In the period from time t12 to time t13, the reset signal changes to the High state to reset the ΔΣ AD converter 10 and the digital demodulating circuit 40. At time t13, the reset signal changes to the Low state, the ΔΣ AD converter 10 starts AD conversion equivalent to a low-order bit string, and the digital demodulating circuit 40 starts demodulation processing of the low-order bit string corresponding to the ΔΣ modulated signal output from the ΔΣ AD converter 10. At time t14, after the end of the demodulation processing equivalent to the low-order bit string, the digital gain adjustment circuit 60 starts digital gain adjustment for a multibit demodulated signal equivalent to the low-order bit string based on the correction values obtained in the correction value obtaining mode. At this time, letting Dlsb be the multibit demodulated signal equivalent to the low-order bit string, a multibit demodulated signal Dlsb_cor after digital gain adjustment is given by equation (2) using Dig(er) and Dig(of):
$Dlsb _ cor = \frac{Dlsb - Dig \left(of\right)}{Dig \left(er\right)}$ (2)

After time t15, the reconstruction circuit 50 outputs a final ADC result (0) using the multibit demodulated signal equivalent to the digital gain-adjusted low-order bit string and the multibit demodulated signal equivalent to the high-order bit string.

Fig. 3 shows a correction value obtaining sequence in the above-described AD conversion circuit 1. The operation of the AD conversion circuit 1 in the correction value obtaining mode shown in Figs. 2A and 2B, and an arithmetic method for obtaining a correction value will be explained with reference to Fig. 3.

In the correction value obtaining sequence, first, in step S301, an AD-converted value obtaining count is determined. In the above description, the AD-converted value obtaining count is two to obtain the AD-converted value (0) and the AD-converted value (1). An AD-converted value obtaining count K can be an arbitrary number of two or more. However, the AD-converted value obtaining count K may be an arbitrary number of one or more, as described above. In accordance with the obtaining count, K types of voltage signals are prepared as reference signals for obtaining a correction value. The digital value of an internal voltage obtained using a coefficient determined by the design value of the ΔΣ AD converter 10 and the K types of reference signals are used in calculation of obtaining a correction value, which will be described below.

Then, in each of steps S302 to S306, the ΔΣ AD converter 10, the residual voltage holding circuit 20, the digital demodulating circuit 40, and the obtaining circuit 70 are used to obtain an AD-converted value (N) using one of the K types of reference signals. As described above, the AD-converted value (N) is held in the memory of the obtaining circuit 70 or the like. After obtaining the AD-converted value (N), if the N value is smaller than K in step S307, the count value N of the obtaining count is incremented by one to be N + 1 in step S308. Then, each of steps S302 to S306 is executed again using another reference signal, obtaining an AD-converted value (N+1). These operations are repeated K times, and after the end of K-time obtainment of AD-converted values, the process shifts to step S309 to execute calculation for obtaining a correction value using the digital value of an internal voltage and the AD-converted values of K times in the obtaining circuit 70. The correction value obtained in the obtaining circuit 70 is held in the memory 90.

A method of calculating a correction value will be explained using an example in which the AD-converted value obtaining count K = 2. VO represents a correction value obtaining reference signal when an AD-converted value is obtained for the first time, Vint0 represents the internal voltage (0) of the ΔΣ AD converter 10 generated upon supplying V0, and Dig(Vint0) represents the digital value of Vint0. V1 represents a reference signal when an AD-converted value is obtained for the second time, Vint1 represents the internal voltage (1) of the ΔΣ AD converter 10 generated upon supplying V1, and Dig(Vint1) represents the digital value of Vint1. Further, Vint0_e and Vint1_e represent the internal voltages (0) and (1) each containing an error arising from the ΔΣ AD converter 10 or the like (for example, the residual voltage holding circuit 20), and Dig_AD(Vint0_e) and Dig_AD(Vint1_e) represent the AD-converted values (0) and (1), respectively. The relationship between the digital value Dig(Vint0) of the internal voltage (0) and the AD-converted value Dig_AD(Vint0_e) is given by equation (3):
$Dig _ AD \left(Vint0_e\right) = Dig \left(er\right) \times Dig \left(Vint0\right) + Dig \left(0f\right)$ (3) Similarly, the relationship between Dig_AD(Vint1_e) and Dig(Vint1) is given by equation (4)
$Dig _ AD \left(Vint1_e\right) = Dig \left(er\right) \times Dig \left(Vint1\right) + Dig \left(0f\right)$ (4) From equations (3) and (4), Dig(er) and Dig(of) are given by equations (5) and (6):
$Dig _ AD \left(er\right) = \frac{Dig _ AD \left(Vint0_e\right) - DigAD \left(Vint1_e\right)}{Dig \left(Vint0\right) - Dig \left(Vint1\right)}$ (5) $Dig \left(of\right) = Dig _ AD \left(Vint0_e\right) - \frac{Dig \left(V0\right) \times \left(Dig_AD\left(Vint0_e\right)-DigAD\left(Vint1_e\right)\right)}{Dig \left(Vint0\right) - Dig \left(Vint1\right)}$ (6)

An error and an offset are calculated as represented by equations (5) and (6), and the digital gain adjustment represented by equation (2) is performed for a demodulated digital signal equivalent to a low-order bit string. This can reduce the error of the internal circuit of the ΔΣ AD converter 10. In this manner, the AD conversion circuit 1 according to this embodiment can digitally correct a nonlinear error generated in the ΔΣ AD converter 10 to reduce the nonlinear error.

When obtaining a plurality of AD-converted values, as described above, the reference voltage may have the same voltage value in obtaining respective AD-converted values. The correction value obtaining mode may be performed before the start of the AD conversion mode, as shown in Figs. 2A and 2B. For example, at the time of activating a device (for example, a photoelectric conversion device PEC to be described later) including the AD conversion circuit 1, an operation in the correction value obtaining mode may be performed to obtain a correction value. While the device starts up and operates, the temperature of the device may change. Considering this, the correction value obtaining mode may be executed at an arbitrary timing in the AD conversion mode. A correction value obtained in the correction value obtaining mode need not always be written in the memory 90 after obtainment, and may be supplied directly from the obtaining circuit 70 to the digital gain adjustment circuit 60.

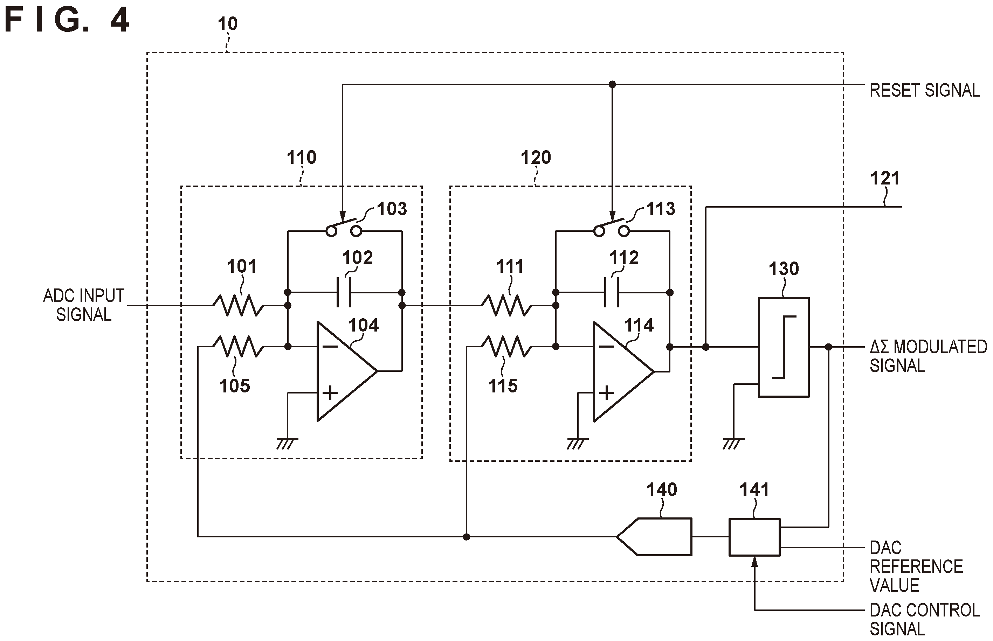

Fig. 4 is a circuit diagram showing a configuration example of the ΔΣ AD converter 10. Fig. 4 shows the configuration of a second-order continuous-time ΔΣ AD converter as a configuration example of the ΔΣ AD converter 10. The ΔΣ AD converter 10 can include a first integrator 110, a second integrator 120 connected to the output of the first integrator, a comparator 130, a digital-to-analog (DA) converter 140, and a multiplexer 141. The first integrator 110 can include, for example, resistors 101 and 105, a capacitor 102, a switch 103, and an amplifier 104. The second integrator 120 can include, for example, resistors 111 and 115, a capacitor 112, a switch 113, and an amplifier 114.

An ADC input signal serving as an input signal of the ΔΣ AD converter 10 is connected to one terminal of the resistor 101 of the first integrator 110. The other terminal of the resistor 101 is connected to the amplifier 104, and one terminal of each of the switch 103, capacitor 102, and resistor 105. The other terminal of the switch 103 and that of the capacitor 102 are connected to the output of the amplifier 104, and an output from the first integrator 110 is supplied to one terminal of the resistor 111 of the second integrator 120. The configuration of the second integrator 120 may be similar to that of the first integrator 110, and an output from the second integrator 120 is input to the comparator 130. The comparator 130 compares, with a reference signal, an output from an integrating circuit constituted by the first integrator 110 and the second integrator 120. The digital demodulating circuit 40 is connected to the output of the comparator 130, and receives an output from the comparator 130. The output from the comparator 130 is input to the DA converter 140 via the multiplexer 141. The DA converter 140 converts the output from the comparator 130 into an analog signal, and supplies the analog signal to the integrating circuit. More specifically, the output from the DA converter 140 is supplied to the other terminal of the resistor 105 of the first integrator 110, and the other terminal of the resistor 115 of the second integrator 120. A node 121 serving as the output of the integrating circuit, more specifically, the output of the second integrator 120 is connected to the residual voltage holding circuit 20. The residual voltage holding circuit 20 holds a signal corresponding to a voltage output from the integrating circuit.

In the ΔΣ AD converter 10 shown in Fig. 4, when the reset signal is in the High state, the capacitors 102 and 112 are reset respectively. When the reset signal is in the Low state, the first integrator 110 integrates a difference voltage between the ADC input signal and the DA converter 140. The second integrator 120 integrates a difference voltage between the output of the first integrator 110 and the DA converter 140. The comparator 130 performs a comparison operation using a clock signal (not shown) for a difference (voltage difference) between the output of the second integrator 120 and the reference signal. When a DAC control signal shown in Fig. 4 is in the Low state, the multiplexer 141 selects the output of the comparator 130, and the DA converter 140 outputs an analog voltage corresponding to the output of the comparator 130. In this fashion, the first integrator 110 and the second integrator 120 may be continuous-time integrators, respectively. The DA converter 140 outputs an analog voltage corresponding to the input in accordance with a 1-bit transfer function given by, for example, equation (7):
$DACOUT \left(DACin\right) = \left\{\begin{matrix}Vr \left(DACin=1\right) \\ 0 \left(DACin=0\right)\end{matrix}\right.$ (7) where DACin is the output of the comparator 130, Vr is the reference voltage (not shown) in the ΔΣ AD converter 10, DACOUT is the output of the DA converter 140, and the reference voltage is 0. In the AD conversion mode, the second-order continuous-time ΔΣ AD converter 10 shown in Fig. 4 repetitively performs the integration operation, the comparison operation, and DA conversion until the reset signal changes from the Low state to the High state.

An example of a method of calculating the digital value of an internal voltage necessary to obtain a correction value in the circuit shown in Fig. 4 will be explained. First, when the DAC control signal is in the High state, the multiplexer 141 selects a DAC reference value. The DA converter 140 DA-converts the selected DAC reference value into a reference voltage Vr. The reference voltage Vr serving as the conversion result is input to the resistor 105 of the first integrator 110. Further, an ADC input signal Va serving as an arbitrary voltage value is supplied to the resistor 101 of the first integrator 110. The first integrator 110 integrates a difference voltage between the input signal Va and the reference voltage Vr during an integration time Ts, and outputs the result to the second integrator 120. The second integrator 120 integrates a difference voltage between the output of the first integrator 110 and the reference voltage Vr during the integration time Ts, and outputs the result as an internal voltage Vint to the node 121. At this time, letting C₁ and C₂ be the capacitance values of the capacitors 102 and 112, respectively, and R₁₁, R₁₂, and R₂₁, and R₂₂ be the resistance values of the resistors 101, 105, 111, and 115, the internal voltage Vint is approximated by equation (8):
$Vint \approx \frac{Ts}{{C}_{2}} \left\{\frac{1}{{R}_{21}}\frac{Ts}{{C}_{1}}\left(\frac{Va}{{R}_{11}}-\frac{Vr}{{R}_{12}}\right)-\frac{Vr}{{R}_{22}}\right\}$ (8)

In equation (8), the capacitance values C₁ and C₂, the resistance values R₁₁, R₁₂, and R₂₁, and R₂₂, the reference voltage Vr, and the integration time Ts are determined by design values, so the internal voltage Vint can be calculated at the circuit design stage. In Fig. 4, voltage-controlled current sources may be used as alternatives of the resistor 105 of the first integrator 110 and the resistor 115 of the second integrator 120. When a voltage-controlled current source having a current value I₁ is used as an alternative to the resistor 105, and a voltage-controlled current source having a current value I₂ is used as an alternative to the resistor 115, equation (8) can be approximated by equation (9):
$Vint \approx \frac{Ts}{{C}_{2}} \left\{\frac{1}{{R}_{21}}\frac{Ts}{{C}_{1}}\left(\frac{Va}{{R}_{11}}-{I}_{1}\right)-{I}_{2}\right\}$ (9) A digital value Dig(Vint) of the internal voltage Vint calculated according to equation (8) or (9) is held as an AD-converted value in the obtaining circuit 70, as described above.

In the circuit configuration shown in Fig. 4, errors are generated in the gain and offset of the internal voltage Vint under the influence of the characteristics of the amplifiers 104 and 114. The error-containing internal voltage Vint is represented as an internal voltage Vint_e. In the correction value obtaining mode, the relationship between an AD-converted value Dig_AD(Vint_e) obtained by AD-converting the internal voltage Vint_e, and the digital value Dig(Vint) is given by equation (10), similar to equations (3) and (4):
$Dig _ AD \left(Vint_e\right) = Dig \left(er\right) \times Dig \left(Vint\right) + Dig \left(of\right)$ (10) Dig(er) and Dig(of) in equation (10) can be obtained in the above-described correction value obtaining mode.

In the configuration shown in Fig. 4, the ΔΣ AD converter 10 is constituted as a second-order continuous-time ΔΣ AD converter. In the ΔΣ AD converter 10, both the comparator 130 and the DA converter 140 have a 1-bit configuration. However, it is also possible to constitute the comparator 130 and the DA converter 140 by a plurality of bits, increase the number of resistors 105 of the first integrator 110 and that of resistors 115 of the second integrator 120 in accordance with the resolutions of the comparator 130 and DA converter 140, and parallelly connect the resistors 105 and 115. Constituting the comparator 130 and the DA converter 140 by a plurality of bits can increase the AD conversion speed of the ΔΣ AD converter 10. Alternatively, a third or higher-order ΔΣ AD converter may be constituted by adding one or more integrators between the second integrator 120 and the comparator 130. Increasing the number of integrators can increase the AD conversion speed of the ΔΣ AD converter 10.

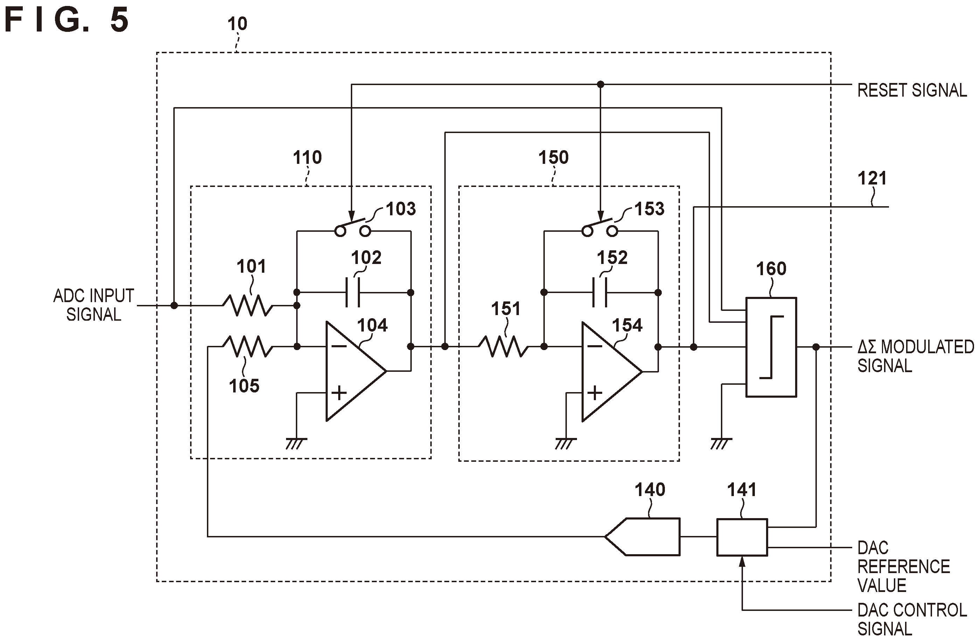

Fig. 5 is a circuit diagram showing another configuration example of the ΔΣ AD converter 10, and shows a second-order continuous-time ΔΣ AD converter having a feedforward path. The ΔΣ AD converter 10 shown in Fig. 5 includes the first integrator 110, and a second integrator 150 that is connected to the output of the first integrator 110 and includes a resistor 151, a capacitor 152, a switch 153, and an amplifier 154. The first integrator 110 has a configuration similar to that shown in Fig. 4. In the configuration shown in Fig. 5, a comparator 160 is a 4-input comparator that compares, with a reference signal, an ADC input signal input to an integrating circuit constituted by the first integrator 110 and the second integrator 150, an output from the first integrator 110, and an output from the second integrator 150. The ADC input signal is a signal input to the first integrator 110.

An output from the first integrator 110 is input to one terminal of the resistor 151 of the second integrator 150, and the other terminal of the resistor 151 is connected to the amplifier 154, and one terminal of each of the switch 153 and capacitor 152. The other terminal of the switch 153 and the other terminal of the capacitor 152 are connected to the output of the amplifier 154. The node 121 serving as the output of the integrating circuit, more specifically, the output of the second integrator 120 is connected to the residual voltage holding circuit 20. A ΔΣ modulated signal serving as an output from the comparator 160 is supplied to the multiplexer 141 and the digital demodulating circuit 40, similar to the configuration shown in Fig. 4. An output from the DA converter 140 that receives an output from the multiplexer 141 is supplied to the other terminal of the resistor 105 of the first integrator 110. Even in the configuration shown in Fig. 5, the first integrator 110 and the second integrator 150 are continuous-time integrators, respectively. The circuit operation of the ΔΣ AD converter 10 shown in Fig. 5 can be similar to the operation of the ΔΣ AD converter 10 shown in Fig. 4.

An example of a method of calculating the digital value of an internal voltage necessary to obtain a correction value in the circuit shown in Fig. 5 will be explained. First, when the DAC control signal is in the High state, the multiplexer 141 selects a DAC reference value. The DA converter 140 DA-converts the selected DAC reference value into the reference voltage Vr. The reference voltage Vr serving as the conversion result is input to the resistor 105 of the first integrator 110. Further, the ADC input signal Va serving as an arbitrary voltage value is supplied to the resistor 101 of the first integrator 110. The first integrator 110 integrates a difference voltage between the input signal Va and the reference voltage Vr during the integration time Ts, and outputs the result to the second integrator 150. The second integrator 150 integrates the output from the first integrator 110 during the integration time Ts, and outputs the result as an internal voltage Vintf to the node 121. At this time, letting C₃ be the capacitance value of the capacitor 152, and R₂₃ be the resistance value of the resistor 151, the internal voltage Vintf is approximated by equation (11), similar to equation (8):
$Vintf \approx \frac{Ts}{{C}_{3}} \left\{\frac{1}{{R}_{23}}\frac{Ts}{{C}_{1}}\left(\frac{Va}{{R}_{11}}-\frac{Vr}{{R}_{12}}\right)\right\}$ (11)

Similar to equation (8), the internal voltage Vintf can be calculated at the circuit design stage. In Fig. 5, a voltage-controlled current source may be used as an alternative to the resistor 105 of the first integrator 110. When a voltage-controlled current source having the current value I₁ is used as an alternative to the resistor 105, equation (11) can be approximated by equation (12):
$Vintf \approx \frac{Ts}{{C}_{3}} \left\{\frac{1}{{R}_{23}}\frac{Ts}{{C}_{1}}\left(\frac{Va}{{R}_{11}}-{I}_{1}\right)\right\}$ (12) A digital value Dig(Vintf) of the internal voltage Vintf calculated according to equation (11) or (12) is held as an AD-converted value in the obtaining circuit 70, as described above.

In the circuit configuration shown in Fig. 5, errors are generated in the gain and offset of the internal voltage Vintf under the influence of the characteristics of the amplifiers 104 and 154. The error-containing internal voltage Vintf is represented as an internal voltage Vintf_e. In the correction value obtaining mode, the relationship between an AD-converted value Dig_AD(Vintf_e) obtained by AD-converting the internal voltage Vintf_e, and the digital value Dig(Vintf) is given by equation (13), similar to equation (10):
$Dig _ AD \left(Vintf_e\right) = Dig \left(er\right) \times Dig \left(Vintf\right) + Dig \left(of\right)$ (13) Dig(er) and Dig(of) in equation (13) can be obtained in the above-described correction value obtaining mode.

In the configuration shown in Fig. 5, the amplitudes of signals output from the first integrator 110 and the second integrator 150 can be suppressed by a path through which the ADC input signal is input to the comparator 160. This can suppress the influence of the nonlinearities of the amplifiers 104 and 154. Hence, the nonlinear distortion characteristic of the ΔΣ AD converter 10 can be improved.

In the configuration shown in Fig. 5, the ΔΣ AD converter 10 is constituted as a second-order continuous-time ΔΣ AD converter. In the ΔΣ AD converter 10, both the comparator 160 and the DA converter 140 have a 1-bit configuration. However, it is also possible to constitute the 4-input comparator 160 and the DA converter 140 by a plurality of bits, increase the number of resistors 105 of the first integrator 110 in accordance with the resolutions of the comparator 160 and DA converter 140, and parallelly connect the resistors 105. Alternatively, a third or higher-order continuous-time ΔΣ AD converter may be constituted by adding one or more integrators between the second integrator 150 and the comparator 160. A plurality of bits of the comparator and DA converter and an increase in the number of integrators can increase the AD conversion speed of the ΔΣ AD converter 10.

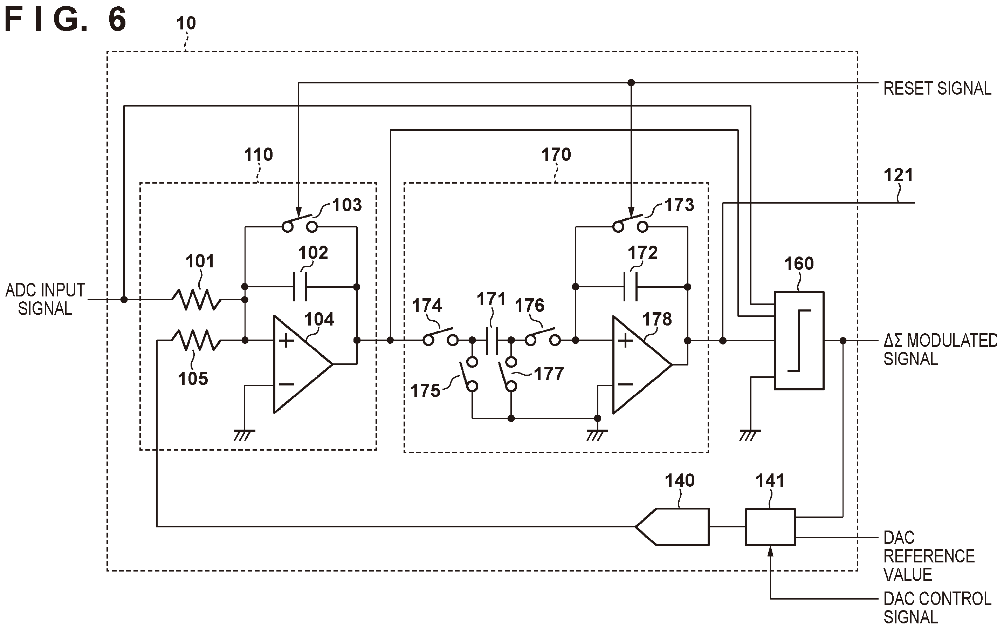

Fig. 6 is a circuit diagram showing another configuration example of the ΔΣ AD converter 10, and shows a second-order hybrid ΔΣ AD converter having a feedforward path. The second-order hybrid ΔΣ AD converter is a ΔΣ AD converter using a continuous-time integrator as the first integrator, and a discrete-time integrator as the second integrator connected to the output of the first integrator. The ΔΣ AD converter 10 shown in Fig. 6 includes the first integrator 110, and a second integrator 170 including capacitors 171 and 172, switches 173, 174, 175, 176, and 177, and an amplifier 178. The configuration of the ΔΣ AD converter 10 shown in Fig. 6 can be similar to the configuration shown in Fig. 5 except the second integrator 170. Thus, the connection relationship between the building elements of the second integrator 170 will be explained below, and a description of relationships that may be similar to the above-described ones will be properly omitted.

An output from the first integrator 110 is input to one terminal of the switch 174 of the second integrator 170, and the other terminal of the switch 174 is connected to one terminal of each of the capacitor 171 and switch 175. The other terminal of the capacitor 171 is connected to one terminal of each of the switches 176 and 177, and the other terminal of the switch 176 is connected to one terminal of each of the switch 173 and capacitor 172, and one input of the amplifier 178. The other terminal of each of the switch 173 and capacitor 172 is connected to the output of the amplifier 178. The other terminal of each of the switches 175 and 177 and the other input of the amplifier 178 are connected to the reference voltage. The node 121 serving as the output of the integrating circuit, more specifically, the output of the second integrator 170 is connected to the residual voltage holding circuit 20. The circuit operation of the ΔΣ AD converter 10 shown in Fig. 6 can be similar to that of the ΔΣ AD converter 10 shown in Fig. 4.

An example of a method of calculating the digital value of an internal voltage necessary to obtain a correction value in the circuit shown in Fig. 6 will be explained. First, when the DAC control signal is in the High state, the multiplexer 141 selects a DAC reference value. The DA converter 140 DA-converts the selected DAC reference value into the reference voltage Vr. The reference voltage Vr serving as the conversion result is input to the resistor 105 of the first integrator 110. Further, the ADC input signal Va serving as an arbitrary voltage value is supplied to the resistor 101 of the first integrator 110. The first integrator 110 integrates a difference voltage between the input signal Va and the reference voltage Vr during the integration time Ts, and outputs the result to the second integrator 170. The second integrator 170 integrates the output from the first integrator 110 during the integration time Ts, and outputs the result as an internal voltage Vinth to the node 121. At this time, letting C₄ and C₅ be the capacitance values of the capacitors 171 and 172, the internal voltage Vinth is approximated by equation (14), similar to equation (8):
$Vinth \approx \frac{{C}_{4}}{{C}_{5}} \left\{\frac{Ts}{{C}_{1}}\left(\frac{Va}{{R}_{11}}-\frac{Vr}{{R}_{12}}\right)\right\}$ (14) Similar to equations (8) and (11), the internal voltage Vinth can be calculated at the circuit design stage. In Fig. 6, a voltage-controlled current source may be used as an alternative to the resistor 105 of the first integrator 110. When a voltage-controlled current source having the current value I₁ is used as an alternative to the resistor 105, equation (14) can be approximated by equation (15):
$Vinth \approx \frac{{C}_{4}}{{C}_{5}} \left\{\frac{Ts}{{C}_{1}}\left(\frac{Va}{{R}_{11}}-{I}_{1}\right)\right\}$ (15) A digital value Dig(Vinth) of the internal voltage Vinth calculated according to equation (14) or (15) is held as an AD-converted value in the obtaining circuit 70, as described above.

In the circuit configuration shown in Fig. 6, errors are generated in the gain and offset of the internal voltage Vinth under the influence of the characteristics of the amplifiers 104 and 178. The error-containing internal voltage Vinth is represented as an internal voltage Vinth_e. In the correction value obtaining mode, the relationship between an AD-converted value Dig_AD(Vinth_e) obtained by AD-converting the internal voltage Vinth_e, and the digital value Dig(Vinth) is given by equation (16), similar to equations (10) and (13):
$Dig _ AD \left(Vinth_e\right) = Dig \left(er\right) \times Dig \left(Vinth\right) + Dig \left(of\right)$ (16) Dig(er) and Dig(of) in equation (16) can be obtained in the above-described correction value obtaining mode.

The ΔΣ AD converter 10 shown in Fig. 6 is a hybrid ΔΣ AD converter in which the integrating circuit is constituted by the first integrator 110 serving as a continuous-time integrator, and the second integrator 170 serving as a discrete-time integrator. Compared to using only a continuous-time integrator, the hybrid ΔΣ AD converter can suppress noise arising from a clock jitter that causes a problem in the continuous-time integrator, and suppress characteristic fluctuations arising from manufacturing variations of a passive element such as a capacitor.

In the configuration shown in Fig. 6, the ΔΣ AD converter 10 is constituted as a second-order hybrid ΔΣ AD converter. In the ΔΣ AD converter 10, both the comparator 160 and the DA converter 140 have a 1-bit configuration. However, it is also possible to constitute the 4-input comparator 160 and the DA converter 140 by a plurality of bits, increase the number of resistors 105 of the first integrator 110 in accordance with the resolutions of the comparator 160 and DA converter 140, and parallelly connect the resistors 105. Alternatively, a third or higher-order hybrid ΔΣ AD converter may be constituted by adding one or more discrete-time integrators between the second integrator 150 and the comparator 160. A plurality of bits of the comparator and DA converter and an increase in the number of integrators can increase the AD conversion speed of the ΔΣ AD converter 10.

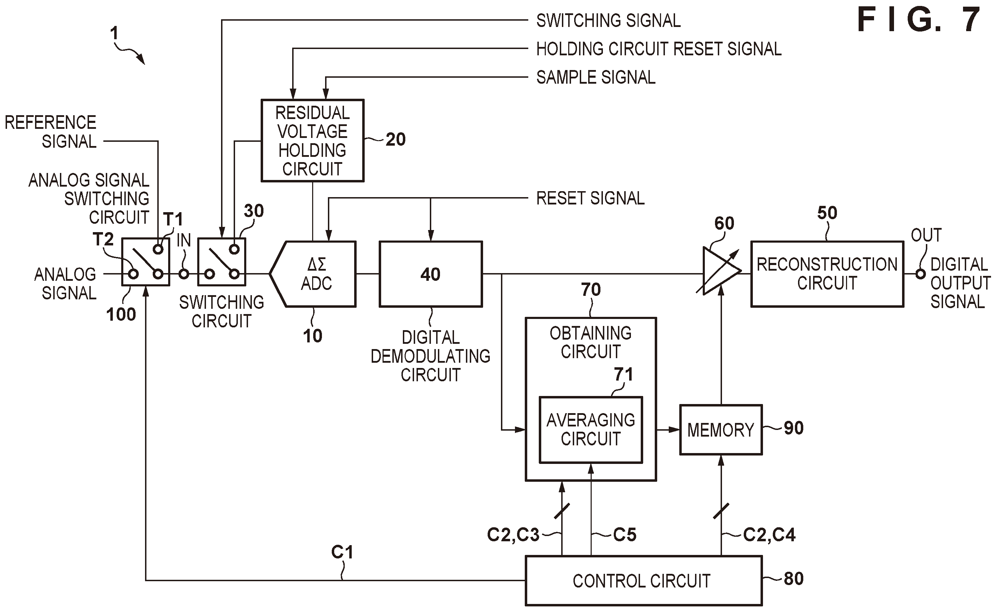

Fig. 7 is a block diagram showing a modification of the AD conversion circuit 1 shown in Fig. 1. In the AD conversion circuit 1 shown in Fig. 7, unlike the AD conversion circuit 1 shown in Fig. 1, the obtaining circuit 70 includes an averaging circuit 71. The remaining configuration may be similar to those described above, so the averaging circuit 71 will be mainly described below, and a description of the configuration that may be similar to the above-described ones will be properly omitted.

The averaging circuit 71 can include a memory that holds an obtained value corresponding to a correction value obtained by the above-described obtaining circuit 70. The averaging circuit 71 averages a plurality of held obtained values. The averaged obtained values are output as correction values from the obtaining circuit 70 (averaging circuit 71) to the memory 90. To control the operation of the averaging circuit 71, the control circuit 80 supplies a control signal C5 to the averaging circuit 71.

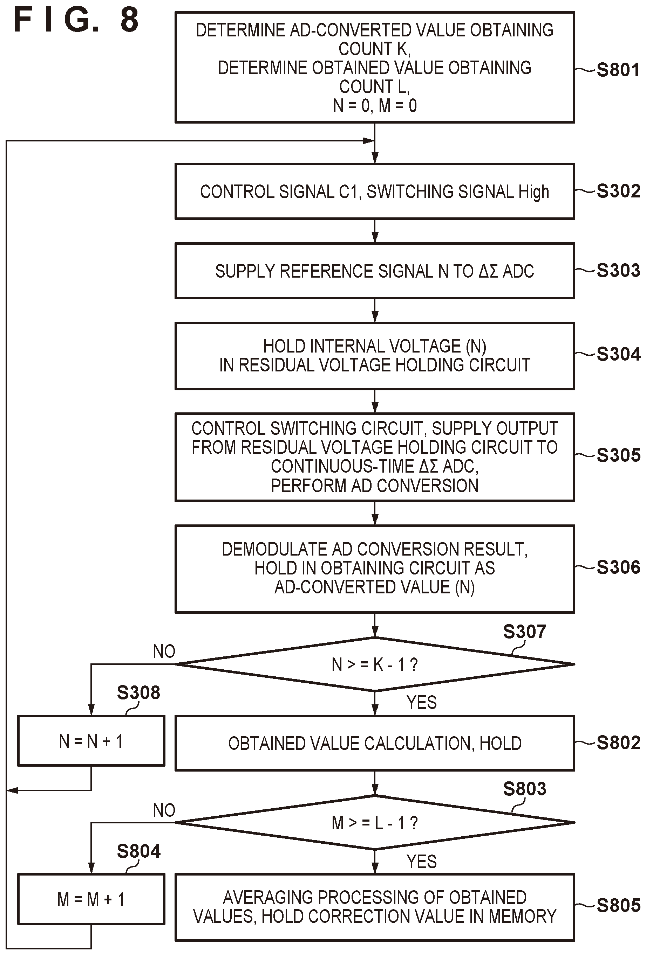

Fig. 8 shows a correction value obtaining sequence in the AD conversion circuit 1 shown in Fig. 7. The operation of the AD conversion circuit 1 including the averaging circuit 71, and an arithmetic method for obtaining a correction value will be explained with reference to Fig. 8. In the obtaining sequence shown in Fig. 8, steps S302 to S308 are similar to those in the obtaining sequence shown in Fig. 3.

First, in step S801, an AD-converted value obtaining count is determined. The AD-converted value obtaining count K can be an arbitrary number of two or more. However, the AD-converted value obtaining count K may be an arbitrary number of one or more, as described above. The obtaining count of an obtained value corresponding to a correction value obtained by the obtaining circuit 70 described with reference to Figs. 1 to 6 is determined. An obtained value obtaining count L can be an arbitrary number of two or more.

Then, in each of steps S302 to S306, the ΔΣ AD converter 10, the residual voltage holding circuit 20, the digital demodulating circuit 40, and the obtaining circuit 70 are used to obtain an AD-converted value (N) using one of K types of reference signals. As described above, the AD-converted value (N) is held in the memory of the obtaining circuit 70 or the like. After obtaining the AD-converted value (N), if the N value is smaller than K in step S307, the count value N of the obtaining count of the AD-converted value is incremented by one to be N + 1 in step S308. Then, each of steps S302 to S306 is executed again using another reference signal, obtaining an AD-converted value (N+1). These operations are repeated K times, and after the end of K-time obtainment of AD-converted values, the process shifts to step S802 to execute calculation in the obtaining circuit 70 in order to obtain an obtained value using the digital value of an internal voltage and the AD-converted values of K times. The obtained value obtained in the obtaining circuit 70 is held in the memory (not shown) of the averaging circuit 71 or the like. After obtaining the obtained value in step S802, if the M value is smaller than L in step S803, the count value M of the obtained value obtaining count is incremented by one to be M + 1 in step S804. These operations are repeated L times, and after the end of L-time obtainment of obtained values, the process shifts to step S805 to execute calculation in the averaging circuit 71 in order to obtain a correction value by averaging the obtained values. The correction value obtained in the averaging circuit 71 is held in the memory 90. The sequence shown in Fig. 8 can be regarded as a sequence in which in the correction value obtaining mode, the obtaining circuit 70 obtains, a plurality of times, digital signals output from the digital demodulating circuit 40 in accordance with reference signals of the same type, and obtains a correction value based on each of the digital signals obtained a plurality of times.

Obtained values (values obtained by digitizing the gain error er and the offset of) are represented as Dig(er)[0], Dig(er)[1], Dig(er)[2],..., Dig(er)[L], and Dig(of)[0], Dig(of)[1], Dig(of)[2],..., Dig(of)[L]. At this time, letting Dig_ave(er) and Dig_ave(of) be correction values obtained by averaging a plurality of obtained values, averaging processing performed by the averaging circuit 71 is given by equations (17) and (18):
$Dig _ ave \left(er\right) = \frac{1}{L} {\sum }_{M = 0}^{L - 1} Dig \left(er\right) \left[M\right]$ (17)
$Dig _ ave \left(of\right) = \frac{1}{L} {\sum }_{M = 0}^{L - 1} Dig \left(of\right) \left[M\right]$ (18)

The correction values generated by averaging processing according to equations (17) and (18) are held in the memory 90. Based on this correction, the digital gain adjustment circuit 60 performs adjustment in the AD conversion mode, similar to the above description. For example, the digital gain adjustment circuit 60 may perform correction value-based gain adjustment for a digital signal of a low-order bit string.

Since the AD-converted value of an internal voltage used to obtain a correction value contains noise of the ΔΣ AD converter 10 or the like, an obtained correction value may vary in only single correction value calculation. Thus, by averaging processing using the averaging circuit 71, the influence of noise of the ΔΣ AD converter 10 or the like can be reduced, obtaining a correction value in which variations arising from noise are suppressed.

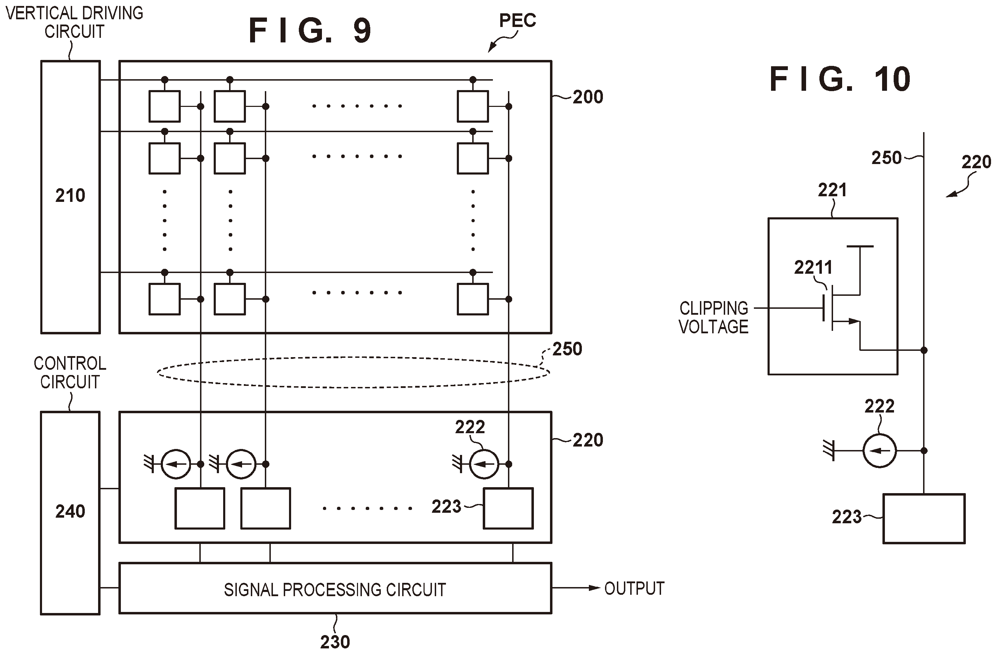

An application example of the above-described AD conversion circuit 1 will be explained. Fig. 9 shows the configuration of the photoelectric conversion device PEC using the AD conversion circuit 1 according to the present disclosure. The photoelectric conversion device PEC can be constituted as a solid-state image sensing device that senses and outputs an image. Alternatively, the photoelectric conversion device PEC can be constituted as a device that senses an image and outputs a signal obtained from the sensed image.

The photoelectric conversion device PEC can include, for example, a pixel array (array constituted by a plurality of pixels each including a photoelectric converter) 200, a vertical driving circuit 210, a readout circuit 220, a control circuit 240, and a signal processing circuit 230. The readout circuit 220 can include a plurality of current sources 222 respectively connected to a plurality of vertical lines 250, and AD conversion circuits 223 that AD-convert signals output from pixels of a selected row to the vertical lines 250. The above-described AD conversion circuit 1 is applicable as each AD conversion circuit 223 of the readout circuit 220.

The photoelectric conversion device PEC can be configured to read out, from the pixel array 200 by the readout circuit 220, a reset level from each pixel and a light signal level generated by photoelectric conversion. The readout circuit 220 can be configured to output a digital signal of the reset level and a digital signal of the light signal level. The signal processing circuit 230 can be configured to perform CDS processing on the digital signal of the reset level and the digital signal of the light signal level, and output a signal having undergone the CDS processing. Since an offset generated in the ΔΣ AD converter 10 is removed by the CDS processing, obtainment of an offset correction value represented by equation (2) can be omitted. In this case, a correction value can be obtained using, for example, only one reference voltage. This can simplify arithmetic processing for obtaining a correction value, and reduce the circuit scale of the obtaining circuit 70. Further, this can shorten the time for obtaining a correction value. As a result, for example, the number of times of the correction value obtaining mode inserted between the AD conversion modes can be increased, implementing higher-precision AD conversion.

The pixel array 200, the vertical driving circuit 210, the readout circuit 220, the control circuit 240, and the signal processing circuit 230 may be arranged on one substrate, distributed to a plurality of substrates and then stacked, or divided into a plurality of chips. The photoelectric conversion device PEC can be a CMOS image sensor. The photoelectric conversion device PEC can be a frontside illumination sensor or a backside illumination sensor.

Fig. 10 is a circuit diagram showing a configuration example of the readout circuit 220 shown in Fig. 9. Fig. 10 shows the configuration of the readout circuit 220 connected to one vertical line 250. The readout circuit 220 may include a clipping circuit 221 in addition to the above-described current source 222 and AD conversion circuit 223. The clipping circuit 221 includes a transistor 2211 that is connected to the vertical line 250 and limits the voltage level in accordance with a clipping voltage supplied to the gate. The transistor 2211 may be, for example, an NMOS transistor. In the configuration shown in Fig. 10, the vertical line 250 is connected to the source of the transistor 2211 serving as an NMOS transistor, the current source 222, and the AD conversion circuit 223. The drain of the transistor 2211 is connected to, for example, the power supply voltage, and the clipping voltage is supplied to the gate from a voltage generation circuit (not shown), as described above. The clipping circuit 221 is a circuit used when limiting the voltage level, for example, maximum voltage of the vertical line 250 serving as a signal line to which the photoelectric converter of the pixel outputs a signal. The clipping circuit 221 is capable of variable control of a voltage to be limited by controlling the clipping voltage.

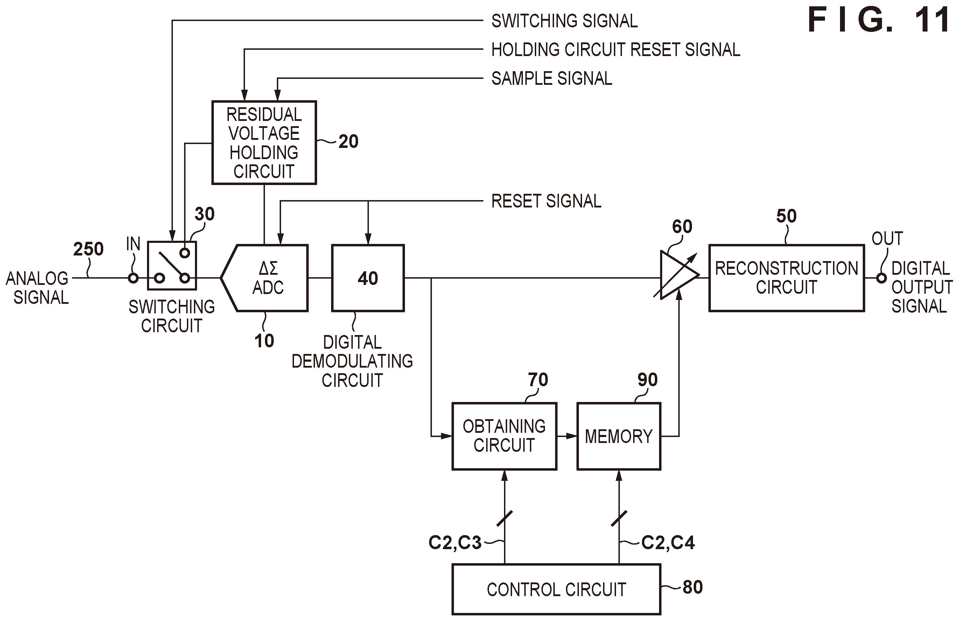

For example, in the correction value obtaining mode, a clipping voltage applied to the clipping circuit 221 is supplied as a correction value obtaining reference voltage to the gate of the transistor 2211. A correction value can therefore be obtained without using the analog signal switching circuit 100 shown in Fig. 1. Hence, the AD conversion circuit 1 may not include the analog signal switching circuit 100, as shown in Fig. 11. In this case, the control signal C1 for controlling the analog signal switching circuit 100 also becomes unnecessary, so the signal generation circuit of the control circuit 80 that generates the control signal C1, and the analog signal switching circuit 100 can be omitted, downsizing the AD conversion circuit 1.

As shown in Fig. 11, the vertical line 250 serving as a signal line to which an analog signal output from the photoelectric converter of the pixel is supplied is connected to the input terminal IN. An analog signal is supplied from the photoelectric conversion element of the pixel in the AD conversion mode, and a reference voltage is supplied to the vertical line 250 using the clipping circuit 221 in the correction value obtaining mode. However, the configuration is not limited to this, and it is also possible to separately arrange the vertical line 250 serving as a signal line to which an analog signal output from the photoelectric converter of the pixel is supplied, and a signal line to which a reference signal is supplied. In this case, the analog signal switching circuit 100 connects, in the AD conversion mode, the input terminal IN and the terminal T2 to which the vertical line 250 is connected, and connects, in the correction value obtaining mode, the input terminal IN and the terminal T1 connected to a signal line to which a reference signal is supplied.

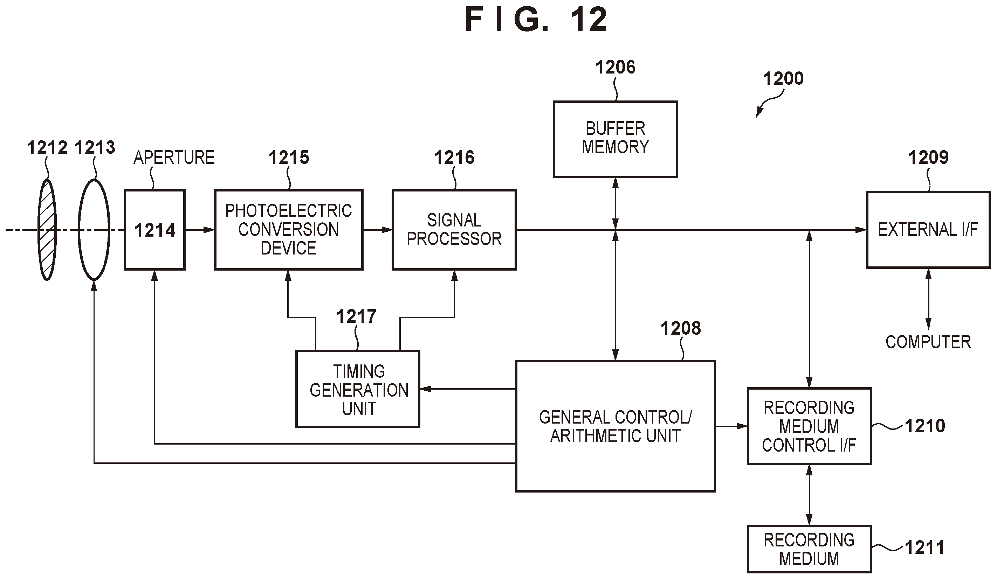

An example of a photoelectric conversion system using the photoelectric conversion device PEC will be described below. Fig. 12 is a block diagram showing the configuration of a photoelectric conversion system 1200 according to an embodiment. The photoelectric conversion system 1200 according to the embodiment includes a photoelectric conversion device 1215. In this case, the photoelectric conversion device PEC described above can be applied as the photoelectric conversion device 1215. The photoelectric conversion system 1200 can be used as, for example, an image capturing system. Specific examples of the image capturing system are a digital still camera, a digital camcorder, and a monitoring camera. Fig. 12 shows an example of the digital still camera (image capturing device) as the photoelectric conversion system 1200.

The photoelectric conversion system 1200 shown in Fig. 12 includes the photoelectric conversion device 1215, a lens 1213 that forms an optical image of an object on the photoelectric conversion device 1215, an aperture 1214 that changes the amount of light passing through the lens 1213, and a barrier 1212 that protects the lens 1213. The lens 1213 and the aperture 1214 form an optical system for concentrating light to the photoelectric conversion device 1215. The photoelectric conversion system used for image capturing is also called an image capturing system.

The photoelectric conversion system 1200 includes a signal processor 1216 that processes an output signal output from the photoelectric conversion device 1215. The signal processor 1216 performs an operation of signal processing of performing various kinds of correction and compression for an input signal, as needed, thereby outputting the resultant signal. The photoelectric conversion system 1200 further includes a buffer memory 1206 for temporarily storing image data, and an external interface unit (external I/F) 1209 for communicating with an external computer or the like. Furthermore, the photoelectric conversion system 1200 includes a recording medium 1211 such as a semiconductor memory for recording or reading out image capturing data, and a recording medium control interface (recording medium control I/F) 1210 for performing a recording or reading operation in or from the recording medium 1211. The recording medium 1211 may be incorporated in the photoelectric conversion system 1200 or may be detachable. In addition, communication with the recording medium 1211 from the recording medium control I/F 1210 or communication from the external I/F 1209 may be performed wirelessly.

Furthermore, the photoelectric conversion system 1200 includes a general control/arithmetic unit 1208 that performs various kinds of arithmetic operations and controls the entire digital still camera, and a timing generation unit 1217 that outputs various kinds of timing signals to the photoelectric conversion device 1215 and the signal processor 1216. Here, the timing signal and the like may be input from the outside, and the photoelectric conversion system 1200 only needs to include at least the photoelectric conversion device 1215 and the signal processor 1216 that processes an output signal output from the photoelectric conversion device 1215. The timing generation unit 1217 may be incorporated in the photoelectric conversion device. The general control/arithmetic unit 1208 and the timing generation unit 1217 may be configured to perform some or all of the control functions of the photoelectric conversion device 1215.

The photoelectric conversion device 1215 outputs an image signal to the signal processor 1216. The signal processor 1216 performs predetermined signal processing for the image signal output from the photoelectric conversion device 1215, and outputs image data. The signal processor 1216 also generates an image using the image signal. Furthermore, the signal processor 1216 may perform distance measurement calculation for the signal output from the photoelectric conversion device 1215. Note that the signal processor 1216 and the timing generation unit 1217 may be incorporated in the photoelectric conversion device. That is, each of the signal processor 1216 and the timing generation unit 1217 may be provided on a substrate on which pixels are arranged, or may be provided on another substrate. An image capturing system capable of acquiring a higher-quality image can be implemented by constituting an image capturing system using the photoelectric conversion device including the above-described AD conversion circuit.

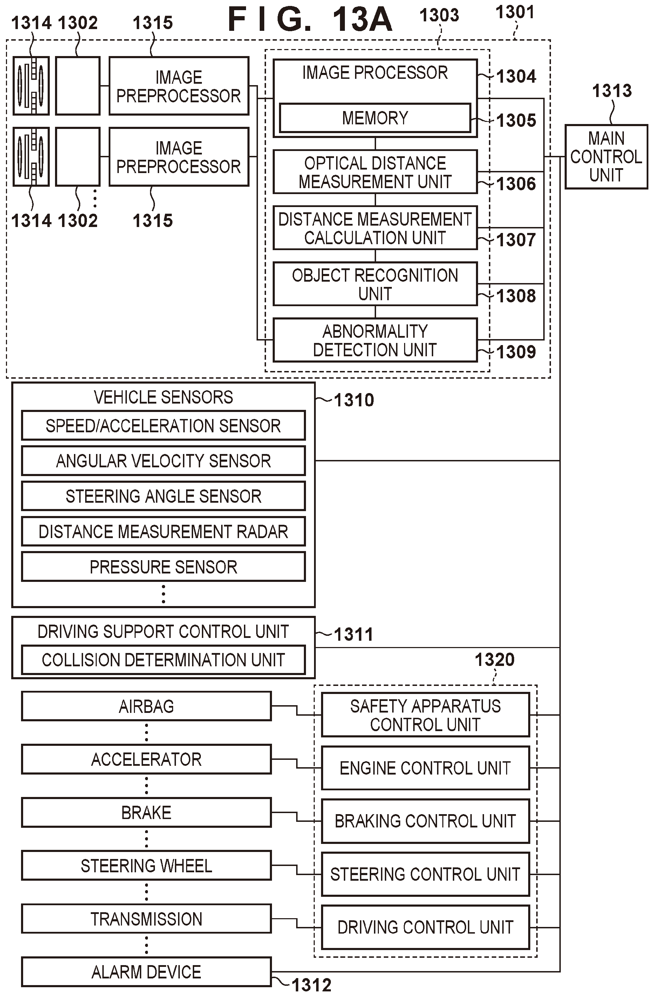

A photoelectric conversion system and a moving body according to another embodiment will be described with reference to Figs. 13A and 13B. Figs. 13A and 13B are views showing a configuration example of the photoelectric conversion system or a configuration example of the moving body, respectively, according to the embodiment. In this embodiment, an example of an in-vehicle camera will be described as the photoelectric conversion system.

Figs. 13A and 13B show examples of a vehicle system and a photoelectric conversion system that is incorporated in the vehicle system and performs image capturing. A photoelectric conversion system 1301 includes a photoelectric conversion device 1302, an image preprocessor 1315, an integrated circuit 1303, and an optical system 1314. The optical system 1314 forms an optical image of an object on the photoelectric conversion device 1302. The photoelectric conversion device 1302 converts, into an electrical signal, the optical image of the object formed by the optical system 1314. The photoelectric conversion device 1302 can be the photoelectric conversion device described above. The image preprocessor 1315 performs predetermined signal processing for the signal output from the photoelectric conversion device 1302. The function of the image preprocessor 1315 may be incorporated in the photoelectric conversion device 1302. In the photoelectric conversion system 1301, at least two sets of the optical systems 1314, the photoelectric conversion devices 1302, and the image preprocessors 1315 are provided, and an output from the image preprocessor 1315 of each set is input to the integrated circuit 1303.

The integrated circuit 1303 is an image capturing system application specific integrated circuit, and includes an image processor 1304 with a memory 1305, an optical distance measurement unit 1306, a distance measurement calculation unit 1307, an object recognition unit 1308, and an abnormality detection unit 1309. The image processor 1304 performs image processing such as development processing and defect correction for the output signal from each image preprocessor 1315. The memory 1305 temporarily stores a captured image, and stores the position of a defect in the captured image. The optical distance measurement unit 1306 performs focusing or distance measurement of an object. The distance measurement calculation unit 1307 calculates distance measurement information from a plurality of image data acquired by the plurality of photoelectric conversion devices 1302. The object recognition unit 1308 recognizes objects such as a vehicle, a road, a road sign, and a person. Upon detecting an abnormality of the photoelectric conversion device 1302, the abnormality detection unit 1309 notifies a main control unit 1313 of the abnormality.

The integrated circuit 1303 may be implemented by dedicated hardware, a software module, or a combination thereof. Alternatively, the integrated circuit 1303 may be implemented by a Field Programmable Gate Array (FPGA), an Application Specific Integrated Circuit (ASIC), or a combination thereof.

The main control unit 1313 comprehensively controls the operations of the photoelectric conversion system 1301, vehicle sensors 1310, a control unit 1320, and the like. A method in which the photoelectric conversion system 1301, the vehicle sensors 1310, and the control unit 1320 each individually include a communication interface and transmit/receive control signals via a communication network (for example, CAN standards) may be adopted without providing the main control unit 1313.

The integrated circuit 1303 has a function of transmitting a control signal or a setting value to each photoelectric conversion device 1302 by receiving the control signal from the main control unit 1313 or by its own control unit.

The photoelectric conversion system 1301 is connected to the vehicle sensors 1310 and can detect the traveling state of the self-vehicle such as the vehicle speed, the yaw rate, and the steering angle, the external environment of the self-vehicle, and the states of other vehicles and obstacles. The vehicle sensors 1310 also serve as a distance information obtaining unit that obtains distance information to a target object. Furthermore, the photoelectric conversion system 1301 is connected to a driving support control unit 1311 that performs various driving support operations such as automatic steering, adaptive cruise control, and anti-collision function. More specifically, with respect to a collision determination function, based on the detection results from the photoelectric conversion system 1301 and the vehicle sensors 1310, a collision with another vehicle or an obstacle is estimated or the presence/absence of a collision is determined. This performs control to avoid a collision when the collision is estimated, or activates a safety apparatus at the time of a collision.

Furthermore, the photoelectric conversion system 1301 is also connected to an alarm device 1312 that generates an alarm to the driver based on the determination result of a collision determination unit. For example, if the determination result of the collision determination unit indicates that the possibility of a collision is high, the main control unit 1313 performs vehicle control to avoid a collision or reduce damage by braking, releasing the accelerator pedal, or suppressing the engine output. The alarm device 1312 sounds an alarm such as a sound, displays alarm information on the screen of a display unit such as a car navigation system or a meter panel, applies a vibration to the seat belt or a steering wheel, thereby giving an alarm to the user.

According to the present disclosure, it is possible to provide a technique advantageous in improving the nonlinear error of the ΔΣ AD converter.

The disclosure of this specification includes an AD conversion circuit, a photoelectric conversion device, an image capturing device, and a moving body described below.

### (Item 1)

An AD conversion circuit configured to be operable in a plurality of modes including an AD conversion mode in which a signal supplied to an input terminal is AD-converted, and a correction value obtaining mode, the AD conversion circuit comprising:
a ΔΣ AD converter including an integrating circuit configured to integrate a difference signal;
a holding circuit configured to hold a signal corresponding to a voltage output from the integrating circuit;
a switching circuit configured to switch a signal to be supplied to the ΔΣ AD converter between a signal supplied to the input terminal and a signal held in the holding circuit;
a digital demodulating circuit configured to generate a digital signal in accordance with a ΔΣ modulated signal output from the ΔΣ AD converter; and
a digital gain adjustment circuit configured to perform gain adjustment for a signal output from the digital demodulating circuit,
wherein the AD conversion circuit further comprises an obtaining circuit configured to obtain, in the correction value obtaining mode, a correction value based on the digital signal output from the digital demodulating circuit in accordance with a correction value obtaining reference signal supplied to the input terminal, and
the gain adjustment in the digital gain adjustment circuit is performed based on the correction value in the AD conversion mode.

### (Item 2)

The AD conversion circuit according to item 1, wherein in the correction value obtaining mode, the switching circuit switches to supply the reference signal to the ΔΣ AD converter in a first period, and supply, to the ΔΣ AD converter in a second period after the first period, a voltage signal held in the holding circuit in accordance with a voltage output from the integrating circuit at an end of the first period, and
the obtaining circuit obtains the correction value based on the digital signal generated by the digital demodulating circuit in accordance with the ΔΣ modulated signal output from the ΔΣ AD converter in the second period.

### (Item 3)

The AD conversion circuit according to item 1, wherein a plurality of types of reference signals including the reference signal are supplied in the correction value obtaining mode, and
the obtaining circuit obtains the correction value based on a plurality of digital signals corresponding to the respective reference signals of the plurality of types output from the digital demodulating circuit.

### (Item 4)

The AD conversion circuit according to any one of items 1 to 3, wherein in the correction value obtaining mode, the obtaining circuit obtains, a plurality of times, digital signals output from the digital demodulating circuit in accordance with reference signals of the same type, and obtains the correction value based on each of the digital signals obtained the plurality of times.

### (Item 5)

The AD conversion circuit according to any one of items 1 to 4, wherein in the AD conversion mode, the switching circuit switches to supply, to the ΔΣ AD converter, the signal supplied to the input terminal in a third period, and supply, to the ΔΣ AD converter in a fourth period after the third period, a voltage signal held in the holding circuit in accordance with a voltage output from the integrating circuit at an end of the third period,
the digital demodulating circuit generates a digital signal of a high-order bit string in accordance with an output from the ΔΣ AD converter in the third period, and generates a digital signal of a low-order bit string in accordance with an output from the ΔΣ AD converter in the fourth period, and
the digital gain adjustment circuit performs gain adjustment based on the correction value for the digital signal of the low-order bit string.

### (Item 6)

The AD conversion circuit according to any one of items 1 to 5, wherein the ΔΣ AD converter further includes a comparator configured to compare an output from the integrating circuit and a reference signal, and a DA converter configured to convert an output from the comparator into an analog signal and supply the analog signal to the integrating circuit.

### (Item 7)

The AD conversion circuit according to item 6, wherein the digital demodulating circuit is connected to an output of the comparator.

### (Item 8)

The AD conversion circuit according to item 6 or 7, wherein the integrating circuit includes a first integrator, and a second integrator connected to an output of the first integrator.

### (Item 9)

The AD conversion circuit according to item 8, wherein the comparator compares an output from the second integrator with the reference signal.

### (Item 10)

The AD conversion circuit according to item 8, wherein the comparator compares, with the reference signal, a signal input to the integrating circuit, an output from the first integrator, and an output from the second integrator.

### (Item 11)

The AD conversion circuit according to any one of items 8 to 10, wherein each of the first integrator and the second integrator includes a continuous-time integrator.

### (Item 12)

The AD conversion circuit according to any one of items 8 to 10, wherein the first integrator includes a continuous-time integrator, and
the second integrator includes a discrete-time integrator.

### (Item 13)

The AD conversion circuit according to any one of items 1 to 12, further comprising a switching circuit other than the switching circuit, the other switching circuit including a first terminal to which an analog signal is supplied from a photoelectric converter of a photoelectric conversion device, and a second terminal to which the reference signal is supplied, and configured to connect the first terminal to the input terminal in the AD conversion mode, and connect the second terminal to the input terminal in the correction value obtaining mode.

### (Item 14)

A photoelectric conversion device comprising:
a photoelectric converter; and
the AD conversion circuit according to any one of items 1 to 13 and configured to convert an analog signal output from the photoelectric converter into a digital signal.

### (Item 15)

A photoelectric conversion device comprising:
a photoelectric converter; and
the AD conversion circuit according to any one of items 1 to 12 and configured to convert an analog signal output from the photoelectric converter into a digital signal,
wherein the photoelectric conversion device further comprises:
   a first signal line to which the analog signal output from the photoelectric converter is supplied;
   a second signal line to which the reference signal is supplied; and
   a switching circuit, other than the switching circuit, configured to connect the first signal line and the input terminal in the AD conversion mode, and connect the second signal line and the input terminal in the correction value obtaining mode.

### (Item 16)

A photoelectric conversion device comprising:
a photoelectric converter; and
the AD conversion circuit according to any one of items 1 to 12 and configured to convert an analog signal output from the photoelectric converter into a digital signal,
wherein the photoelectric conversion device further comprises a signal line connected to the input terminal and to which the analog signal output from the photoelectric converter is supplied, and
in the correction value obtaining mode, the reference signal is supplied to the signal line.

### (Item 17)

The photoelectric conversion device according to item 16, further comprising a clipping circuit configured to limit a voltage level of the signal line,
wherein the clipping circuit includes a transistor connected to the signal line and configured to limit the voltage level in accordance with a clipping voltage supplied to a gate, and
the reference signal is set via the clipping voltage.

### (Item 18)

An image capturing device comprising:
the photoelectric conversion device according to any one of items 14 to 17; and
a signal processor configured to process a signal output from the photoelectric conversion device.

### (Item 19)

A moving body characterized by comprising the image capturing device according to item 18.

Various embodiments have been described in detail above but it will be understood that the present disclosure is not limited to these embodiments and encompasses all modifications, variants, alternatives and equivalents falling within the scope of the appended claims.

## Claims

1. An AD conversion circuit (1) configured to be operable in a plurality of modes including an AD conversion mode in which a signal supplied to an input terminal (IN) is AD-converted, and a correction value obtaining mode, the AD conversion circuit (1) **characterized by** comprising:
a ΔΣ AD converter (10) including an integrating circuit configured to integrate a difference signal;
a holding circuit configured to hold a signal corresponding to a voltage output from the integrating circuit;
a switching circuit (30) configured to switch a signal to be supplied to the ΔΣ AD converter (10) between a signal supplied to the input terminal (IN) and a signal held in the holding circuit;
a digital demodulating circuit (40) configured to generate a digital signal in accordance with a ΔΣ modulated signal output from the ΔΣ AD converter (10); and
a digital gain adjustment circuit (60) configured to perform gain adjustment for a signal output from the digital demodulating circuit (40),
wherein the AD conversion circuit (1) further comprises an obtaining circuit (70) configured to obtain, in the correction value obtaining mode, a correction value based on the digital signal output from the digital demodulating circuit (40) in accordance with a correction value obtaining reference signal supplied to the input terminal (IN), and
the gain adjustment in the digital gain adjustment circuit (60) is performed based on the correction value in the AD conversion mode.

2. The AD conversion circuit according to claim 1, **characterized in that** in the correction value obtaining mode, the switching circuit switches to supply the reference signal to the ΔΣ AD converter in a first period, and supply, to the ΔΣ AD converter in a second period after the first period, a voltage signal held in the holding circuit in accordance with a voltage output from the integrating circuit at an end of the first period, and
the obtaining circuit obtains the correction value based on the digital signal generated by the digital demodulating circuit in accordance with the ΔΣ modulated signal output from the ΔΣ AD converter in the second period.

3. The AD conversion circuit according to claim 1 or 2, **characterized in that** a plurality of types of reference signals including the reference signal are supplied in the correction value obtaining mode, and
the obtaining circuit obtains the correction value based on a plurality of digital signals corresponding to the respective reference signals of the plurality of types output from the digital demodulating circuit.

4. The AD conversion circuit according to any one of claims 1 to 3, **characterized in that** in the correction value obtaining mode, the obtaining circuit obtains, a plurality of times, digital signals output from the digital demodulating circuit in accordance with reference signals of the same type, and obtains the correction value based on each of the digital signals obtained the plurality of times.

5. The AD conversion circuit according to any one of claims 1 to 4, **characterized in that** in the AD conversion mode, the switching circuit switches to supply, to the ΔΣ AD converter, the signal supplied to the input terminal in a third period, and supply, to the ΔΣ AD converter in a fourth period after the third period, a voltage signal held in the holding circuit in accordance with a voltage output from the integrating circuit at an end of the third period,
the digital demodulating circuit generates a digital signal of a high-order bit string in accordance with an output from the ΔΣ AD converter in the third period, and generates a digital signal of a low-order bit string in accordance with an output from the ΔΣ AD converter in the fourth period, and
the digital gain adjustment circuit performs gain adjustment based on the correction value for the digital signal of the low-order bit string.

6. The AD conversion circuit according to any one of claims 1 to 5, **characterized in that** the ΔΣ AD converter further includes a comparator configured to compare an output from the integrating circuit and a reference signal, and a DA converter configured to convert an output from the comparator into an analog signal and supply the analog signal to the integrating circuit.

7. The AD conversion circuit according to claim 6, **characterized in that** the integrating circuit includes a first integrator, and a second integrator connected to an output of the first integrator.

8. The AD conversion circuit according to claim 7, **characterized in that** the comparator compares an output from the second integrator with the reference signal.

9. The AD conversion circuit according to claim 7, **characterized in that** the comparator compares, with the reference signal, a signal input to the integrating circuit, an output from the first integrator, and an output from the second integrator.

10. The AD conversion circuit according to any one of claims 7 to 9, **characterized in that** each of the first integrator and the second integrator includes a continuous-time integrator.

11. The AD conversion circuit according to any one of claims 7 to 9, **characterized in that** the first integrator includes a continuous-time integrator, and
the second integrator includes a discrete-time integrator.

12. The AD conversion circuit according to any one of claims 1 to 11, **characterized by** further comprising a switching circuit other than the switching circuit, the other switching circuit including a first terminal to which an analog signal is supplied from a photoelectric converter of a photoelectric conversion device, and a second terminal to which the reference signal is supplied, and configured to connect the first terminal to the input terminal in the AD conversion mode, and connect the second terminal to the input terminal in the correction value obtaining mode.

13. A photoelectric conversion device **characterized by** comprising:
a photoelectric converter; and
the AD conversion circuit according to any one of claims 1 to 12 and configured to convert an analog signal output from the photoelectric converter into a digital signal.

14. A photoelectric conversion device **characterized by** comprising:
a photoelectric converter; and
the AD conversion circuit according to any one of claims 1 to 10 and configured to convert an analog signal output from the photoelectric converter into a digital signal,
wherein the photoelectric conversion device further comprises a signal line connected to the input terminal and to which the analog signal output from the photoelectric converter is supplied, and a clipping circuit configured to limit a voltage level of the signal line,
in the correction value obtaining mode, the reference signal is supplied to the signal line,
the clipping circuit includes a transistor connected to the signal line and configured to limit the voltage level in accordance with a clipping voltage supplied to a gate, and
the reference signal is set via the clipping voltage.

15. An image capturing device **characterized by** comprising:
the photoelectric conversion device according to claim 13 or 14; and
a signal processor configured to process a signal output from the photoelectric conversion device.
